(19) Europäisches Patentamt / European Patent Office / Office européen des brevets

(11) **EP 3 943 197 A1**

(12) # EUROPEAN PATENT APPLICATION

(43) Date of publication:
**26.01.2022 Bulletin 2022/04**

(21) Application number: **20186825.4**

(22) Date of filing: **20.07.2020**

(51) International Patent Classification (IPC):
**B05B 7/22** (2006.01)     **B82Y 30/00** (2011.01)
**C23C 14/04** (2006.01)     **C23C 14/22** (2006.01)
**C23C 14/28** (2006.01)     **H01J 49/04** (2006.01)

(52) Cooperative Patent Classification (CPC):
**C23C 14/048; B05B 7/228; C23C 14/228;**
**C23C 14/28; C23C 14/5806;** B82Y 30/00

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **The Provost, Fellows, Scholars and other**
**Members of Board of Trinity College Dublin**
**Dublin 2 (IE)**

(72) Inventors:
• **Lupoi, Rocco**
  **Dublin 2, (IE)**
• **Lunney, James**
  **Dublin 2, (IE)**

(74) Representative: **Purdylucey Intellectual Property**
**6-7 Harcourt Terrace**
**D02 FH73 Dublin 2 (IE)**

(54) **JET DEPOSITION USING LASER-PRODUCED DRY AEROSOL**

(57)     A method of generating nanoparticles to a print head, the method comprising generating a contaminant-free nanoparticle stream from a feedstock material in an atmospheric gas flow using a laser ablation system at atmospheric pressure.

Figure 1

## Description

### Field of the Invention

The invention relates to a direct-write deposition method for depositing functional structures onto a target.

### Background to the Invention

The additive manufacturing (AM) market has emerged in recent years as a significant technology trend. The AM market goes by many different names such as 3D printing, material deposition, printed electronics *etc.* The market has numerous technical solutions with associated different advantages/disadvantages and specific solutions frequently find alignment within a given segment. For example - there are desktop fusion deposition modelling (FDM) systems that sell for a few hundred euros and are used to make various plastic devices - through to very expensive inkjet presses manufacturing metal parts in commercial product lines. The scale and variation of these AM markets allows for multiple AM technology solutions to exist.

Functioning elements such as conducting elements (an antenna, interconnect, wiring, electromagnetic interference (EMI) shielding, for example) or non-conducting elements (such as capacitive, strain or environmental sensors), are the fundamental building blocks of most current technical solutions - for example, antennas are required for transceivers for connectivity. The technology requirements of these functioning elements are becoming ever more stringent as the associated product solutions become more complicated - an example being the requirement for multiple antennas in a smartphone (36/4G/5G/near filed communication (NFC)/WIFI®/Bluetooth® *etc*) and the associated EMI shielding requirements of multiple chips. This evolution has resulted in product suppliers having to employ different AM approaches. Thus, most chips within a modern smartphone have EMI shielding applied - and have multiple antennas fabricated in a range of different ways, materials and locations.

A further example is the application of power electronics, which in turn is driven by the rise of electric vehicles and the application of efficient BLDC (Brushless DC) motors. These applications require higher operating temperatures and packaging solutions featuring improved packaging wiring.

US 8132744 describes a technology solution known as aerosol jetting process (AJP), which comprises an aerosol stream that is focused and deposited onto a planar or non-planar target, forming a pattern that is thermally or photochemically processed to achieve physical, optical, and/or electrical properties near that of the corresponding bulk material. The problem with this solution is that post-processing steps require the removal of fluidic components/solvents that were used in depositing the material initially. The use of a liquid base material with nanoparticles is expensive and the substrate needs to be hydrophilic, which slows down the speed at which deposition proceed, and limits the range of substrate materials that can be used.

It is an object of the present invention to overcome at least one of the above-mentioned problems.

### Summary of the Invention

The invention described herein generally involves the generation of particles (for example, nanoparticles) of a feedstock material using an atmospheric laser ablation method for mesoscale (10 $\mu$m - 1 mm) mask-free deposition of dry aerosols of functional materials. The particles are generated in a flow of gas that is focused through a nozzle. More specifically, the invention relates to a method of jet deposition using a dry aerosol produced by pulsed laser ablation of the feedstock material to be deposited. The aerosol jet may be deposited directly onto a substrate or may be focused to mesoscale dimensions using aerodynamic focusing. The substrate may be planar, or non-planar. The pulsed laser ablation is carried out in an ablation cell containing a feedstock of the material to be deposited and filled with flowing gas at atmospheric pressure. The laser is repetitively pulsed (at a rate of 1 Hz to 100 MHz), and the duration of the individual laser pulses lies in the range 500 nanosecond (ns) to 5 femtosecond (fs). The laser enters the ablation cell through a transparent window, and is focused on the feedstock material using a suitable lens. To ensure uniform ablation of the feedstock material, the laser beam is scanned over the material, or the material is moved in the laser beam.

The laser ablation process produces an ablation plume of feedstock material vapour, plasma or nanoparticles at high pressure. The ablation plume expands into the gas. The expansion is slowed by the counter pressure and inertia of the gas and will come to a halt when its dimensions are 0.1 mm to 30 mm, depending on the energy of each laser pulse and on gas density. The spatial confinement of the ablation plume expansion promotes the condensation of nanoparticles. The nanoparticle ablation plume is captured by the flowing gas, forming a nanoparticle aerosol, and carried out of the ablation cell to a jet deposition head. Coagulation of the nanoparticles usually occurs, forming larger particles. A jet of the particulate aerosol is directed at a suitable substrate, where it is deposited. The particles adhere to a target site at specific locations as defined by the nozzle. These particles can be subsequently sintered to form a solid material which forms the part of a functioning element or coating layer. The jet may be focused to smaller dimensions using an aerodynamic lens. The substrate can be moved relative to the print head to form fine lines or layers of deposit. The potential geometries are of sufficient accuracy that they can be used as functioning elements in microelectronics, through to power electrics, or as a coating on the target site.

In general, the aerosol of coagulated nanoparticles will lead to the formation of a porous deposit. For most applications it will be necessary to provide some form of further processing to obtain the required physical and/or electrical properties. Firstly, the sintering can be done *in situ* by using a laser, or plasma, to supply heat to the aerosol jet near the substrate, or at the deposition site. The substrate may also be heated. Secondly, the sintering may be carried out in a post-deposition process by heating with a plasma or a laser, or in an oven. The heating may be performed in the presence or absence of a vacuum, in the presence or absence of an inert atmosphere, or a combination thereof.

There are several key advantages of this approach over existing conductive ink and aerosolized based systems. These include.

1. Potential ability to generate particles from any feedstock material.
2. Ease of handling of very small particles
3. Cost-effective generation of very small particles.
4. Uncontaminated generation of particles (no carrier ink).
5. Improved adherence of particles to a target site.
6. Increased throughput at much reduced costs.
7. Increased flexibility - can change target materials (*i.e.* to improve adhesion), particle size, modifications *etc.*
8. Much more environmentally friendly with no post processing chemicals or lead required.
9. By using a laser for the ablation step, the applicant can separately control the particle generation and the particle carrier gas flow - leading to a significantly improved process control.

The method of the claimed invention has much reduced costs and a much higher throughput than existing AJP systems. Additionally, the ability to generate particles from any feedstock material and easily switch feedstock materials during the steps of the method can potentially facilitate the manufacture of completely new product classes.

It is envisaged that particles may be generated within an inert gas flow and with sufficient thermal energy that they may form a semi-dense conductive line or coating (layer) on the target site. It may then be possible to sinter these semi-dense lines or coatings within the inert gas using a laser. This will allow for the immediate creation of metal lines or coatings on substrates at very low temperatures.

There is provided, as set out in the appended claims, a method of generating dry nanoparticles for printing, the method comprising generating a contaminant-free dry nanoparticle stream from a feedstock material in an atmospheric gas flow using a laser ablation system at atmospheric pressure, wherein the contaminant-free dry nanoparticles are directed to a substrate through a nozzle by the gas flow in a dry state and adhere to the substrate to produce conductive, semi-conductive, functional, or 3D geometric structures, or combinations thereof.

In one aspect, the method further comprises the step of heating the atmospheric gas flow to facilitate sintered structures on deposition.

In one aspect, the method further comprises the step of sintering the particles within the atmospheric gas flow prior to deposition to the substrate.

In one aspect, the method further comprises the step of sintering the particles after deposition.

Preferably, the sintering step is a combination of being conducted within the atmospheric gas flow prior to deposition and following deposition of the particles.

In one aspect, the feedstock material is selected from a metal, a non-metal, an insulator, or a combination thereof. Preferably, the metal is selected from copper, silver, gold, platinum, gallium, aluminium, and alloys thereof. Preferably, the non-metal is selected from carbon, graphite, graphene, single-walled carbon nanotubes, multi-wall carbon nanotubes, boron nitride, a ceramic, a polymer, a non-metal insulator (such as glass), a non-metal semiconductor (such as silicon, germanium, gallium nitride), a metal oxide (such as titanium oxide, copper oxide, aluminium oxide, silver oxide, platinum oxide, gallium oxide, and combinations thereof (but not limited to).

In one aspect, the gas is inert. Preferably, the gas is selected from air, argon, nitrogen, helium, neon, krypton, xenon, or a combination thereof. Preferably, the step of sintering the particles within the gas flow or following particle deposition is by heating, laser irradiation, plasma treatment. Ideally, the heating is in an oven or a furnace, in the presence or absence of an inert atmosphere, or in the presence or absence of a vacuum, or a combination thereof.

In one aspect, the distance between the nozzle tip and the substrate is between about 0.01 mm and about 15 mm. Preferably, the distance is about 0.1-10 mm.

In one aspect, the velocity of the gas flow within the ablation cell is between about 0.1 m/s to about 1000 m/s.

In one aspect, the velocity of the gas flow leaving the nozzle is between about 0.1 m/s (subsonic) to about 1000 m/s.

In one aspect, the particles are deposited on the substrate in a line having a width of between about 5 $\mu$m and 400 $\mu$m.

In one aspect, the particles are deposited on the substrate as a coating or a layer.

In one aspect, the laser is a pulsed laser with a pulse duration in the range of about 500 nanoseconds ($500 \times 10^{-9}$ s) to about 5 femtoseconds ($5 \times 10^{-15}$ s).

In one aspect, the laser has a wavelength in the range from ultra-violet (150 nm) to far infra-red (20 $\mu$m).

In one aspect, the substrate is made from glass, carbon, ceramic, silicon, metal, or combinations thereof.

In one aspect, the feedstock material is a conductive or non-conductive material selected from a metal, a ceramic, an insulator, a polymer, or a super-conductor as described above, or combinations thereof.

In one aspect, there is provided a dry aerosol jet deposition apparatus (1) comprising an ablation cell (2) and a print head (3); the ablation cell (2) comprising a housing (4) defining a chamber (5) adapted to accommodate a feedstock material (10), a transparent window (6), a gas inlet (7), and an aerosol outlet (8); the print head (3) comprising a nozzle (3a) with a tip (3b); wherein the nozzle (3a) comprises an inner cylindrical channel (18) in fluid communication with an outer converging channel (19) that joins the channel (18) at an angle of between about 90° relative to the inner cylindrical channel (18), and a jet aperture (22).

In one aspect, the apparatus further comprises a lens (12) located between a laser source and the ablation cell (2), and adjacent the transparent window (6).

In one aspect, the nozzle (3a) further is defined by an outer wall (3c), an inner wall (3d), a distal end (3e) and a proximal end (3f).

In one aspect, the tip (3b) tapers inwards towards a jet aperture (22).

In one aspect, the jet aperture (22) has a diameter of between about 200 to about 400 μm.

In one aspect, the apparatus further comprises an aerodynamic lens.

In one aspect, there is provided a product produced by the method described above.

In one aspect, the product is selected from an aerosoliser, a wearable device, an EMI shield, an antenna, an RFID shield, a sensor, a catheter interface, a medical device, home healthcare telemetry, a light, smartphone antennas, consumer electronic antennas, automotive electrical interconnects, IOT/MMIC/5C interconnects, middle interconnect devices.

In one aspect, the polymer is a thermoplastic which may be selected from, but not limited to, the group comprising acrylonitrile butadiene styrene, polypropylene (PP), polyethylene, polyvinylchloride, polyamide, polyester, acrylic, polyacrylic, polyacrylonitrile, polycarbonate, ethylene-vinyl acetate, ethylene vinyl alcohol, polytetrafluoroethylene, ethylene chlorotrifluoroethylene, ethylene tetrafluoroethylene, liquid crystal polymer, polybutadiene, polychlorotrifluoroehtylene, polystyrene, polyurethane, and polyvinyl acetate.

In one aspect, the polymer is a thermoset which may be selected from, but not limited to, the group comprising vulcanised rubber, Bakelite (polyoxybenzylmethylenglycolanhydride), urea-formaldehyde foam, melamine resin, polyester resin, epoxy resin, polyimides, cyanate esters or polycyanurates, silicone, and the like known to the skilled person.

In one aspect, the polymer is an elastomer which may be selected from, but not limited to, the group comprising polybutadiene, butadiene and acrylonitrile copolymers (NBR), natural and synthetic rubber, polyesteramide, chloropene rubbers, poly(styrene-b-butadiene) copolymers, polysiloxanes (such as polydimethylsiloxane (PDMS)), polyisoprene, polyurethane, polychloroprene, chlorinated polyethylene, polyester/ether urethane, poly ethylene propylene, chlorosulphanated polyethylene, polyalkylene oxide and mixtures thereof.

In one aspect, the polymer is a biopolymer which may be selected from, but not limited to, the group comprising gelatin, lignin, cellulose, polyalkylene esters, polyvinyl alcohol, polyamide esters, polyalkylene esters, polyanhydrides, polylactide (PLA) and its copolymers and polyhydroxyalkanoate (PHA).

In one aspect, the polymer is a copolymer selected from, but not limited to, the group comprising copolymers of propylene and ethylene, acetal copolymers (Polyoxymethylenes), polymethylpentene copolymer (PMP), amorphous copolyester (PETG), acrylic and acrylate copolymers, polycarbonate (PC) copolymer, styrene block copolymers (SBCs) to include poly(styrene-butadiene-styrene) (SBS), poly(styreneisoprene-styrene) (SIS), poly(styrene-ethylene/butylene-styrene) (SEBS), ethylene vinyl acetate (EVA) and ethylene vinyl alcohol copolymer (EVOH) amongst others.

In one aspect, the laser has a wavelength of between about 150 nm (UV) to about 11 μm (infrared).

*Definitions*

In the specification, the terms "plastic" and "polymer" should be understood to mean a material consisting of any of a wide range of synthetic or semi-synthetic organic compounds that are malleable and so can be moulded into solid objects. The terms can be used interchangeably. Plastics or polymers can be grouped into thermoplastics, thermosetting polymers, amorphous plastics, crystalline plastics, conductive polymers, biodegradable polymers, bioplastics, and the like.

In the specification, the term "sensor" should be understood to mean a component used to measure strain, temperature, gas, chemicals, pressure, and the like.

In the specification, the term "wearable device" should be understood to mean a smart device that can be worn by the user. For example, a smart watch, a smart phone, a medical device.

In the specification, the term "virtual impactor" should be understood to mean a device used to separate particles by size into two airstreams. It is similar to a conventional impactor, but the impaction surface is replaced with a virtual space of stagnant or slow-moving air. Large particles are captured in a collection probe rather than impacted onto a surface.

In the specification, the term "ceramic" should be understood to mean a solid material comprising an inorganic compound of metal or metalloid and non-metal with ionic or covalent bonds. Common examples are earthenware, porcelain, brick, and cermet (a composite material of ceramic and metal). Examples of a cermet include barium titanate, bismuth strontium calcium copper oxide, boron oxide, boron nitride, ferrite, lead zirconate titanate, silicon carbide, silicon nitride, titanium carbide, zinc oxide, zirconium dioxide.

In the specification, the term "feedstock material" should be understood to mean the material selected for ablation in the ablation cell and deposition on a target site.

**Brief Description of the Drawings**

The invention will be more clearly understood from the following description of an embodiment thereof, given by way of example only, with reference to the accompanying drawings, in which:-

Figure 1 illustrates a schematic drawing of the dry aerosol jet deposition apparatus of the claimed invention, showing an ablation cell (particle generator), a jet deposition head, and a substrate mounted on a computer-controlled translation/rotation stage.

Figure 2A illustrates a schematic drawing of the apparatus of the claimed invention where uniform ablation is achieved by one aspect of the invention where the target is moved while the laser is kept fixed. The focused laser beam is kept fixed while a cylindrical rod of the target material is rotated and translated beneath the focused laser beam. The aerosol is carried away by gas flow across the ablation site. Figure 2B illustrates where the laser is moved over a flat feedstock material.

Figure 3 illustrates a schematic drawing showing an aerodynamic lens being used in the apparatus of the claimed invention to focus the aerosol jet.

Figure 4 illustrates silver lines deposited at standoff distances of 1, 2, 3, 4, and 5 mm using the apparatus and method of the claimed invention.

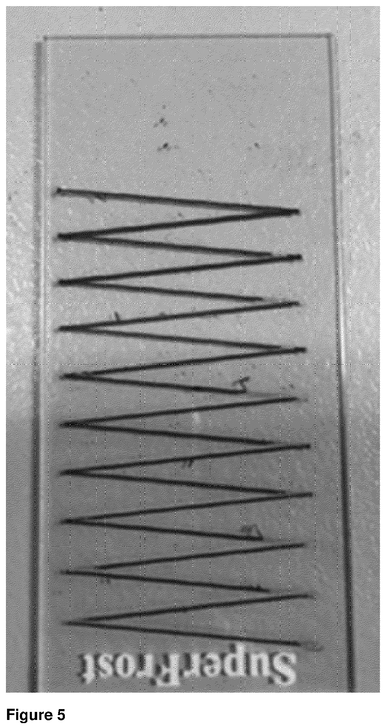

Figure 5 illustrates zig-zag line 38 cm long deposited on a glass slide to measure build rate using the method and apparatus of the claimed invention.

Figure 6 is a bar chart illustrating the comparison of build rates obtained using the laser produced dry aerosol (3 W) method of the claimed invention, and the Optomec Aerosol Jet® system of the prior art.

Figure 7 illustrates a scanning electron microscope (SEM) image of a silver track deposited using the laser produced dry aerosol method and apparatus of the claimed invention.

Figure 8A and 8B are SEM images of the as-deposited material at two different magnifications.

Figure 9A and 9B are SEM images of the laser sintered deposited material at two different magnifications.

**Detailed Description of the Drawings**

In the present invention, the dry aerosol, produced by laser ablation of a solid target of the functional (feedstock) material, is enclosed in an ablation cell containing a suitable flowing gas at atmospheric pressure. The laser enters the ablation cell through a suitable transparent window. Suitable gases include inert gases, such as noble gases or nitrogen, for materials subject to oxidation; or air for the ablation of materials not subject to oxidation, such as noble metals or ceramics. The range of functional feedstock materials of interest includes metals, insulators, semiconductors, polymers and ceramics. The laser ablation is done using a repetitively pulsed laser with pulse duration in the range 500 nanoseconds ($500 \times 10^{-9}$ s) to 5 femtoseconds ($5 \times 10^{-15}$ s). The laser should be significantly absorbed by the feedstock material, and should have a wavelength in the range from ultra-violet (150 nanometer ($50 \times 10^{-9}$ m)) to far infra-red (20 microns ($20 \times 10^{-6}$ m)). To obtain pulsed laser ablation the laser is focused on the surface of the feedstock material to generate a temperature causing vigorous evaporation, typically above the boiling point temperature of the material. For each laser pulse, an amount of the feedstock material leaves the surface as a vapour, and in some cases as a plasma. Uniform removal of material from the surface of the feedstock material is achieved by moving the ablation spot in a suitable manner: either by scanning the laser beam while keeping the feedstock material fixed, moving the feedstock material while keeping the laser fixed, or moving both the laser and the feedstock material.

The laser ablation process produces an ablation plume of feedstock material vapour, plasma or nanoparticles at high pressure. The ablation plume expands into the gas, and the expansion is slowed by the counter pressure and inertia of the gas, and will come to a halt when the plume dimensions are 0.1 mm to 30 mm, depending on the energy of each laser pulse and the gas density, that is, the expansion is halted by the ablation material expanding against a combination of the pressure and inertia of the gas atmosphere. (T.E. Itina and A. Voloshko, Appl. Phys. B (2013) 113:473-478). The spatial confinement of the ablation plume expansion promotes the condensation of nanoparticles. The nanoparticle ablation plume is captured by the flowing gas, forming a nanoparticle aerosol, which is carried out of the ablation cell to the jet deposition head. The typical gas flow velocity over the target surface is between about 0.1 m/s (subsonic) to about 1000 m/s (supersonic). As the aerosol is transported to the deposition head, coagulation of the nanoparticles will occur, forming larger particles with size in the $\mu$m range.

The stream of particulate aerosol leaving the particle generator is formed into a jet by passing it through a suitable aperture, and directed at a suitable substrate, where it is deposited. The shape and dimensions of the jet are controlled by the shape and dimensions of the jet aperture. The substrate can be moved relative to the print head to form fine lines of deposit, or to obtain a uniform coating. The jet may be focused to smaller dimensions using an aerodynamic lens. Typically, the standoff distance between the jet aperture and the substrate is 0.1 - 10 mm. The substrate can be moved relative to the print head to form fine lines of deposit, or to obtain a uniform coating.

In general, the aerosol of coagulated nanoparticles will lead to the formation of a porous deposit. For most applications it will be necessary to provide some form of further processing, for example heat application, to obtain the required physical and/or electrical properties. Firstly, the sintering can be done *in situ* by using a laser or plasma to supply heat to the aerosol jet near the substrate, or at the deposition site. The substrate may also be heated. Secondly, the sintering may be carried out in a post deposition process by heating with a plasma or laser, or in an oven. The heating may be carried in a vacuum, or not, and/or in an inert atmosphere, or not, or combinations thereof.

The approach potentially allows for low temperature and conformal deposition of functioning structures. These structures may be conductive lines, antennas, or sensors, for example. This allows the deposition of functioning metal lines on a range of locations and configurations for different products. These metal lines can be used as conductive or signal lines. This approach can potentially greatly reduce product complexity, increase reliability and cost as these metal structures often require dedicated components (PCB's *etc*).

This "printed electrics" approach is considered important for the establishment of key platform technologies such as 5G, MMIC, IoT and electric power. These platform technologies will underpin consumer electronics, range finding, industrial, medical, pharmaceutical and transport markets in the future.

*Apparatus*

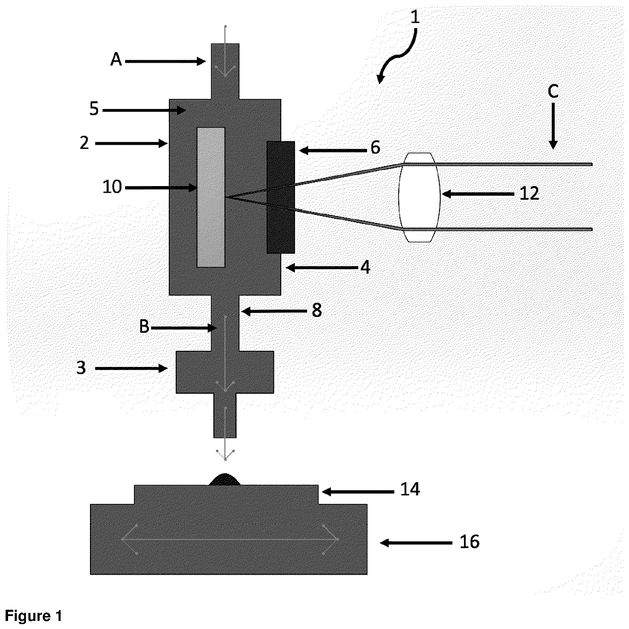

The apparatus of the claimed invention will now be described, where **Figure 1** illustrates a general embodiment of a dry aerosol jet deposition apparatus of the present invention. Specifically, **Figure 1** illustrates a cross-section view of the dry aerosol jet deposition apparatus of the claimed invention and is generally referred to by reference numeral 1. The apparatus 1 typically comprises an ablation cell 2 in fluid communication with a deposition or print head 3.

The ablation cell 2 comprises a housing 4 defining a chamber 5, a transparent window 6 on one side of the housing 4, a gas inlet 7 and an aerosol outlet 8. The aerosol outlet 8 is in fluid communication with the deposition head 3. The chamber 5 of the housing 4 accommodates a feedstock material 10.

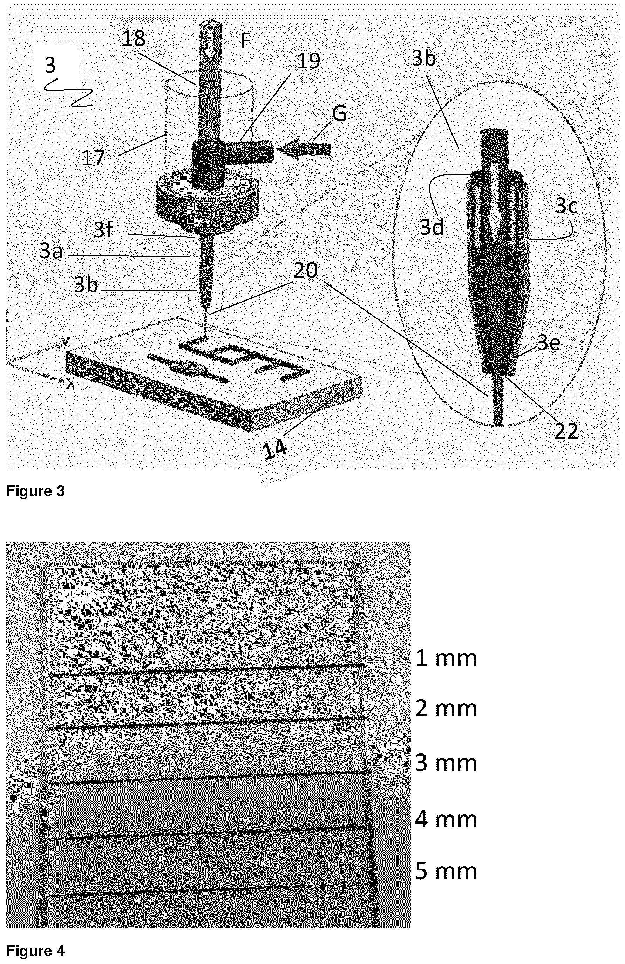

Typically, the deposition head 3 is a jet deposition head having a nozzle 3a with a tip 3b. The deposition head 3, as shown in more detail in **Figure 3,** further comprises an outer wall 17 encompassing an inner cylindrical channel 18 in fluid communication with an outer converging channel 19 that joins the channel 18 at an angle of about 90° relative to the inner cylindrical channel 18. The inner cylindrical channel 18 is in fluid communication with the nozzle 3a. The nozzle 3a comprises an outer wall 3c, an inner wall 3d, a distal end 3e and a proximal end 3f. The distal end 3e comprises the tip 3b, which tapers inwards towards a jet aperture 22.

The apparatus 1 also includes a lens 12 adjacent the transparent window 6 and positioned between a laser source and the transparent window 6. The lens 12 focuses a laser beam (arrow C) before it enters the transparent window 6 to act upon the feedstock material 10 within the chamber 5 and generate ablated feedstock material.

*Particle Generator/Ablation Cell*

The particle generator or ablation cell 2 is described above and contains a solid mass of the feedstock material 10 to be deposited. A vapour, or plasma, of the feedstock material 10 is formed by pulsed laser ablation. The ablation plume of abated material is confined by the counter pressure and inertia of the gas, followed by condensation of the vapour to form nanoparticles in the size range of about 1 to 150 nm, preferably between about 3 to about 100 nm, and finally coagulation of the nanoparticles to form nanoparticle aggregates in the size range of about 100 nm to about 3 $\mu$m. The nanoparticle aggregates are mixed with the gas and carried out of the ablation cell 2 as an aerosol jet flow (as per arrow B in **Figure 1**). A virtual impactor may be used to increase the particulate concentration in the aerosol flow. The transparent window 6 is used to admit the laser beam. The material of the transparent window 6 is not critical, so long as it is transparent. Materials which can be used are, for example, quartz, sapphire, glass, and the like.

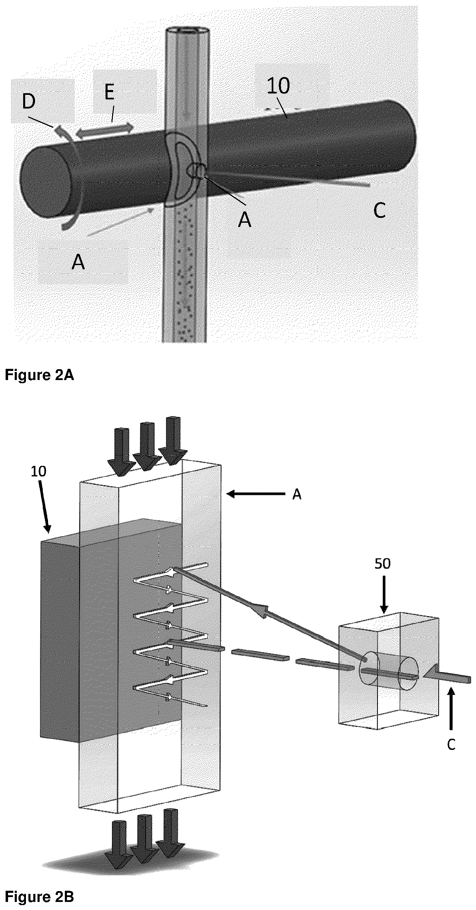

The flow of gas (arrow A) through the ablation cell 2 carries the ablated feedstock material to the deposition head 3 via the aerosol jet flow (arrow B), and on to a substrate 14 where it is deposited. To obtain uniform deposition, or produce a deposition pattern, the substrate 14 is moved relative to the deposition head 3 using a computer-controlled translation/rotation stage 16. Uniform removal of material from the surface of the feedstock material 10 is achieved by moving the ablation spot on the feedstock material 10 in a suitable manner: (i) moving the feedstock material 10 while keeping the laser fixed, (ii) scanning the laser beam (arrow C) while keeping the feedstock material 10 fixed, or (iii) moving both the laser and the feedstock material 10. **Figure 2A** shows the scheme (i) whereby the focused laser beam (arrow C) is kept fixed while a cylindrical rod of the feedstock material 10 is rotated (arrow D) and translated (arrow E) beneath the focused laser beam (arrow C). For (ii), as shown in **Figure 2B,** a flat feedstock material 10 is held stationary in the ablation cell 2 and the focused laser beam (arrow C) is scanned across the feedstock material 10 using a computer controlled laser beam scanner 50. The flow of gas (arrow A) is consistent in both Figure 2A and Figure 2B.

*Jet Deposition*

*Without aerodynamic focusing*

The stream of particulate aerosol leaving the ablation cell 2 is formed into an aerosol jet stream 20 (see **Figure 3**) by passing it through the jet aperture 22, and directed at the substrate 14, where it is deposited. The shape and dimensions of the aerosol jet stream 20 are controlled by the shape and dimensions of the jet aperture 22. The substrate 14 can be moved relative to the print head 3 to form various deposition patterns, or a uniform coating. Alternatively, the print head 3 can be moved relative to the substrate 14, or both the substrate 14 and the print head 3 can move relative to each other.

*With aerodynamic focusing*

The aerosol jet stream 20 may be focused to smaller dimensions using an aerodynamic lens, based on a coaxial nozzle, as shown in **Figure 3.** The aerosol flow $(Q_a)$ (arrow F) enters the inner cylindrical channel 17, while the sheath gas flow $(Q_s)$ (arrow G) enters the outer converging channel 19. The diameter $(D_j)$ of the aerosol jet stream 20 leaving the nozzle 3a is given by

$$D_j = D_n \sqrt{Q_a / Q_t} \, ,$$

where $Q_t$ is the total gas flow, given by $Q_t = Q_a + Q_s$. The sheath gas also acts to prevent deposition of aerosol particulates on the inner surface of the inner wall 3d of the nozzle 3a. Typically, the standoff distance between the jet aperture 22 and the substrate 14 is 0.1-10 mm. The substrate 14 can be moved relative to the deposition head 3 to form various deposition patterns, including fine lines with widths down to about 5 $\mu$m. Alternatively, the print head 3 can be moved relative to the substrate 14, or both the substrate 14 and the print head 3 can move relative to each other.

*Working distance*

The working distance of the laser from the substrate 14 was estimated by visually inspecting the deposition at nozzle 3a to tip 3b distances of 1, 2, 3, 4, and 5 mm. A laser power of 3W, speed RPM of 90, and flow rates of 33 CC/min and 100 CC/min were used for the carrier and sheath gas respectively.

*Build rates*

The build rate was measured by spraying a -38 cm line onto a glass slide and measuring the mass difference ($\Delta$m) using the same parameters as above.

*Results and Discussion*

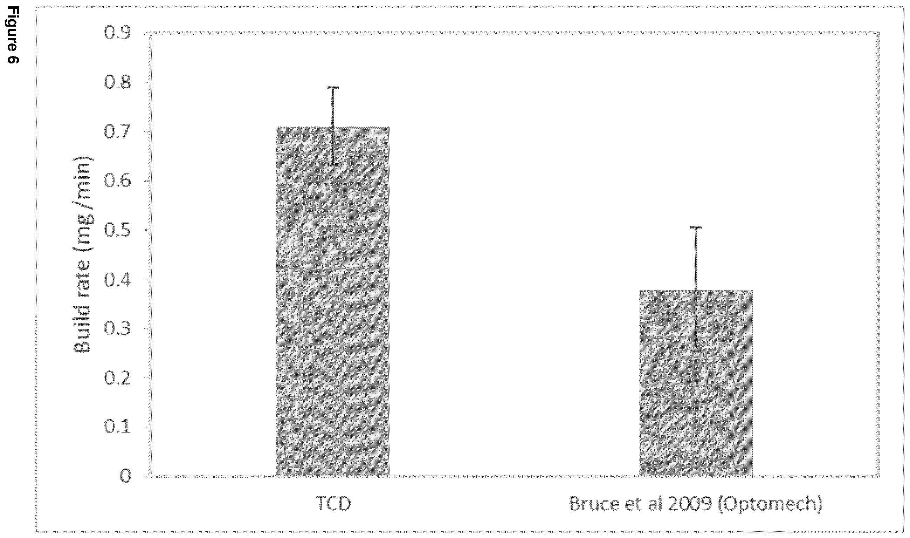

**Figure 4** shows some examples of silver lines deposited with the apparatus 1 of the claimed invention. A high repetition rate fibre laser operating at a wavelength of about 1 $\mu$m (1.065 $\mu$m) and a pulse duration of about 250 ns was used. The laser was operated at a pulse repetition rate of about 5 kHz and the average power was 3 W. The laser was focused using a 20 cm lens. The lens was positioned so that the surface of the silver target was about 1 mm beyond the focus, giving a peak fluence in the laser spot of about 20 J cm$^{-2}$, which is sufficient to cause ablation of the feedstock material. The feedstock material was rotated at 90 RPM and translated at between about 0.005 cm s$^{-1}$ and about 1 cm s$^{-1}$. Argon gas at atmospheric pressure was fed into the particle generator at a rate of 33 standard cubic centimeters per minute (sccm). This gas flow carries the silver aerosol into the deposition head, which was equipped with an aerodynamic lens to reduce the diameter of the aerosol jet leaving the nozzle. The diameter of the nozzle was 300 microns. The sheath gas was fed into the aerodynamic lens at a rate of 100 sccm. Line depositions were made on the glass substrates using a scan rate of 5 mm s$^{-1}$, and various values of standoff distance. **Figure 4** shows lines deposited at standoff distances of 1, 2, 3, 4, and 5 mm.
The measured build rate was compared with the typical rate obtained using the Aerosol Jet® system. (King, Bruce H., Michael J. O'Reilly, and Stephen M. Barnes. 2009. "Characterizing Aerosol Jet® Multi-Nozzle Process Parameters for Non-Contact Front Side Metallization of Silicon Solar Cells." Conference Record of the IEEE Photovoltaic Specialists Conference, 001107-11. https://doi.org/10.1109/PVSC.2009.5411213.). It should be noted that the laser power was only 3 W. Pulsed lasers with average power up to about 300-500 W are readily available, and, with average powers increasing all the time, the build rate can be correspondingly increased. **Figure 6** clearly shows that the build rate using the apparatus of the claimed invention is superior to that of the build rate using an apparatus of the prior art.

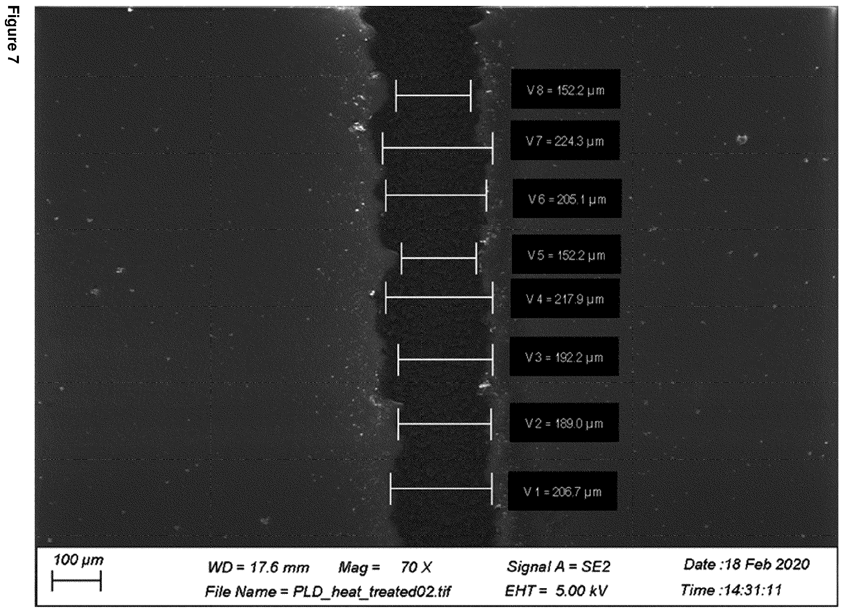

**Figure 7** shows a scanning electron microscope (SEM) picture of silver track deposited using the apparatus of the claimed invention. The track width varies from 150 micron to 200 micron. According to the aerodynamic focusing equation (see above), using an aerosol flow $(Q_a)$ of 33 sccm, a sheath gas flow $(Q_s)$ of 100 sccm, and a 300 micron nozzle, the expected line width is 150 micron.

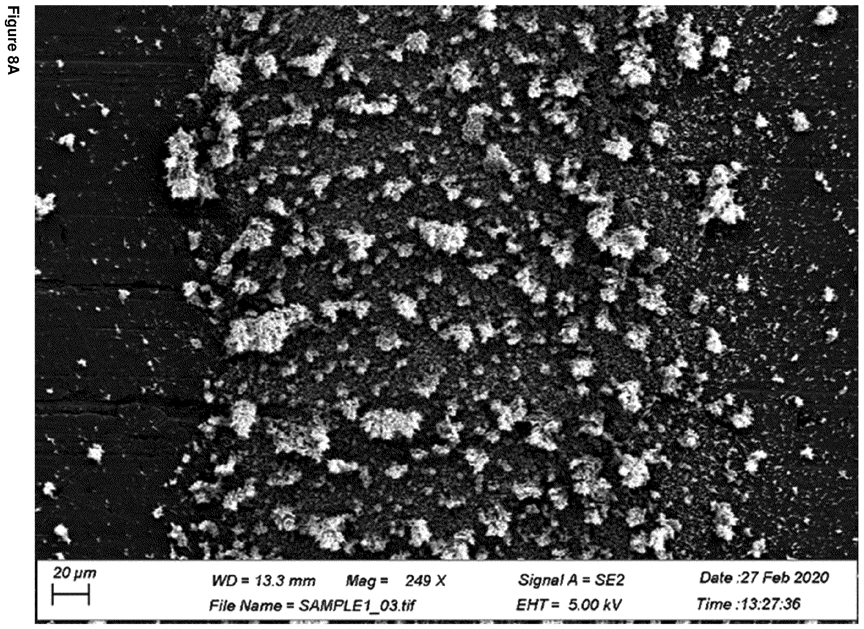

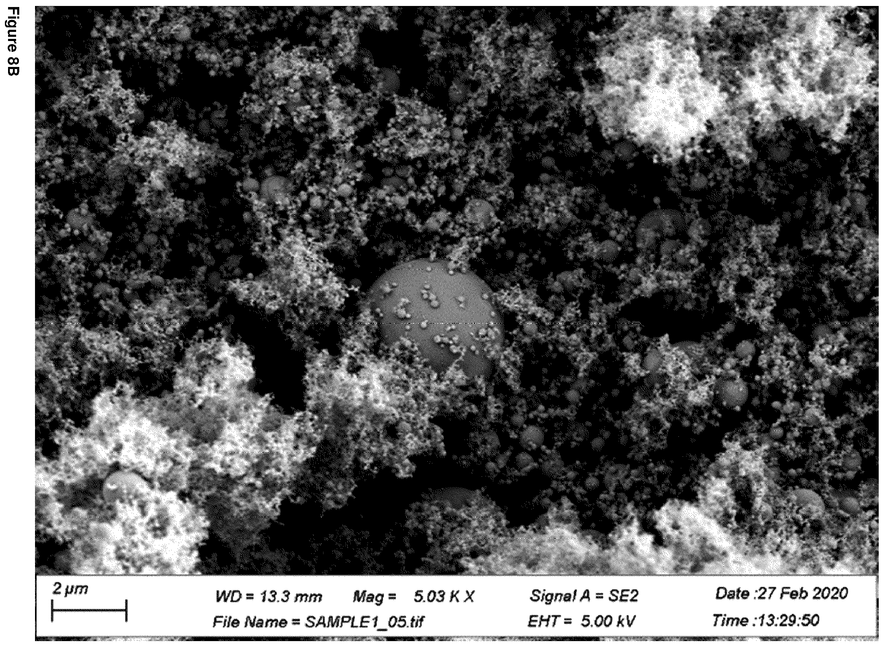

**Figure 8A** and **Figure 8B** show an SEM image of the as-deposited material at two different magnifications. The lower magnification image reveals the highly porous nature of the deposit, as would be expected for the assembly of aggregated metal nanoparticles. The individual nanoparticles can be seen in the higher magnification image. The larger highly spherical particles seen in this image are most likely due to liquid droplets expelled from the target during the ablation process.

Electrical resistivity measurements

The electrical resistance of the deposited tracks was measured by depositing a track between two silver paint pads separated by 15 mm and using a multi-meter to measure the resistance. For a 15 mm long line deposited at a mass loading of $2.3 \times 10^{-3}$ mg mm$^{-1}$, the resistance was found to be 390 ohms ($\Omega$), which corresponds to 26 $\Omega$ mm$^{-1}$. The resistance of a 15 mm long bulk silver line at the same mass loading is 1.1 $\Omega$, which corresponds to 0.073 $\Omega$ mm$^{-1}$. As expected, the resistance of the as-deposited tracks have a much higher resistance than bulk silver lines with the same mass loading.

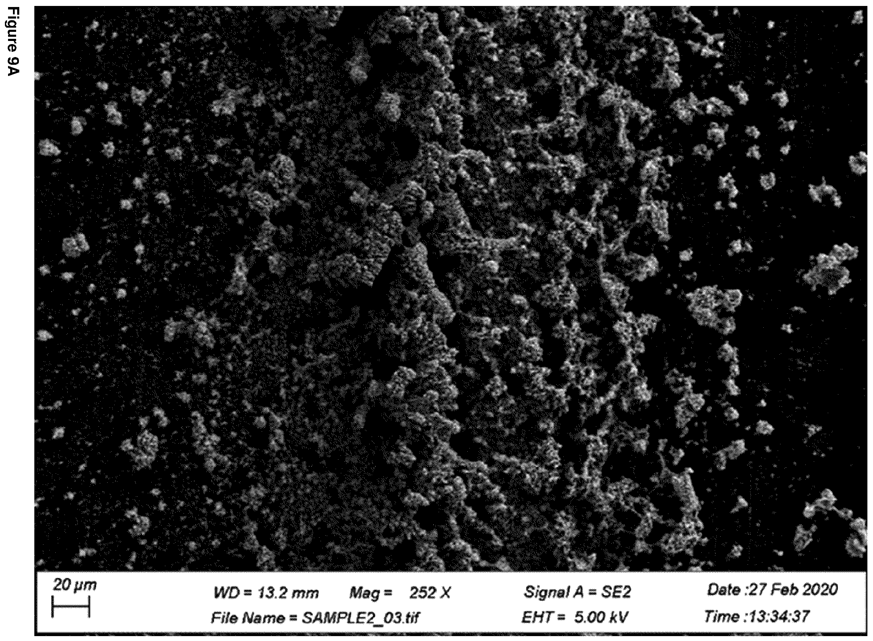

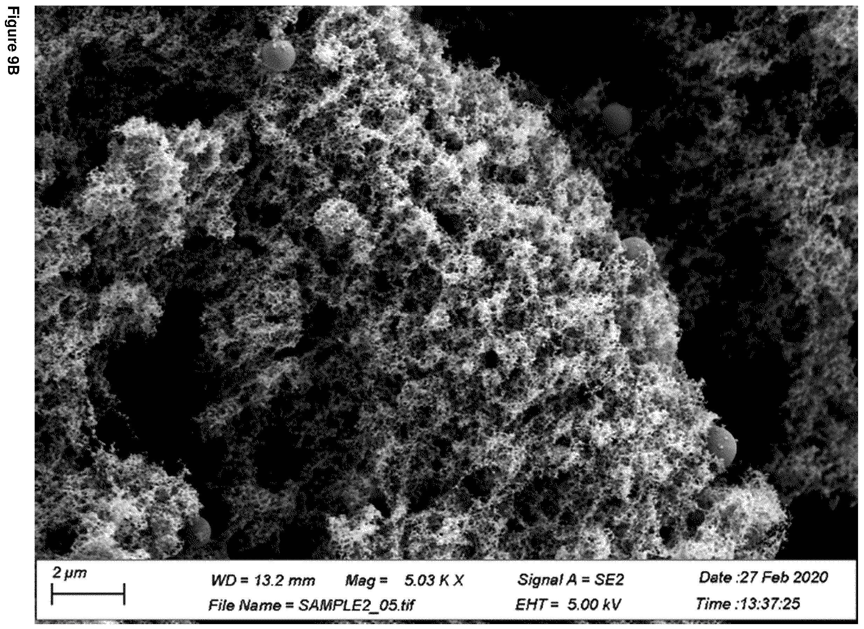

Various sintering methods were investigated to reduce the electrical resistance of the silver tracks. These were: (i) furnace annealing in air at 200°C for 1 - 4 hours, (ii) irradiation with a 100 W infra-red lamp focussed through a 10 mm diameter output aperture and scanned over the silver tracks at 5 and 2.5 mm s$^{-1}$, and (iii) irradiation with a 45 W continuous $CO_2$ (10.6 $\mu$m) laser focussed to a 6 mm diameter spot and scanned over the silver tracks at 10 mm s$^{-1}$. The largest reduction in resistance was obtained using laser sintering where it was found that resistance of a 15 mm long track decreased from 350 $\Omega$ before sintering, to 32 $\Omega$ after laser sintering. This corresponds to 2.1 $\Omega$ mm$^{-1}$, which is about 30 times higher than a bulk silver line with the same mass per unit length. Visually, the as-deposited tracks appear black, but have a shinier appearance after annealing. **Figure 9A** and **Figure 9B** show two different magnification images of the laser sintered material.

The advantages of the described invention are, for example, that the particles are uncontaminated when ablated, unlike the particles of the prior art which are contaminated by a fluidic carrier medium. This improves the options, efficiency and ease for post-processing treatment if required. By the use of a laser for the ablation step, and by separating the particle generation from the particle carrier gas flow, the method significantly improves process control over the size of the particles that can be generated, without affecting the carrier flow dynamics. This allows for the creation of very small particles. Typically, these particles are very difficult to handle and are very expensive. However, the claimed invention allows for ease of handling and associated hugely reduced costs. Smaller particles are known to sinter much easier and at lower temperatures. Particle energy can be varied by changing the laser parameters depending on applications - for example, to improve adhesion or ease of sintering. The system could be combined with an additional sintering system to facilitate sintering of the deposited particles within the inert gas flow environment (for example, a sintering laser focussed on the target deposition point).

In the specification the terms "comprise, comprises, comprised and comprising" or any variation thereof and the terms "include, includes, included and including" or any variation thereof are considered to be totally interchangeable and they should all be afforded the widest possible interpretation and vice versa.

The invention is not limited to the embodiments hereinbefore described but may be varied in both construction and detail.

**Claims**

1. A method of generating dry nanoparticles for printing, the method comprising generating a contaminant-free dry nanoparticle stream from a feedstock material in an atmospheric gas flow using a laser ablation system at atmospheric pressure, wherein the contaminant-free dry nanoparticles are directed to a substrate through a nozzle by the gas flow in a dry state and adhere to the substrate to produce conductive, semi-conductive, functional, or 3D geometric structures, or combinations thereof.

2. The method of Claim 1, further comprising the step of heating the atmospheric gas flow to facilitate sintered structures on deposition.

3. The method of Claim 1 or Claim 2, further comprising the step of sintering the particles within the atmospheric gas flow prior to deposition to the substrate; further comprising the step of sintering the particles after deposition; or further comprising the step of sintering the particles within the atmospheric gas flow prior to deposition and following deposition of the particles.

4. The method of Claim 3, wherein the step of sintering the particles within the gas flow or following particle deposition is by heating, laser irradiation, plasma treatment.

5. The method of any one of Claims 1 to 4, wherein the feedstock material is selected from a metal, a non-metal, or a combination thereof.

6. The method of any one of the preceding claims, wherein the gas is inert.

7. The method of any one of the preceding claims, wherein the distance between the nozzle tip and the substrate is between about 0.01 mm and about 15 mm.

8. The method of any one of the preceding claims, wherein the velocity of the gas flow within the ablation cell, leaving the nozzle, or both, is between about 0.1 m/s to about 1000 m/s.

9. The method of any one of the preceding claims, wherein the particles are deposited on the substrate as a line, a coating, or a layer.

10. The method of any one of the preceding claims, wherein the laser is a pulsed laser with a pulse duration in the range of about 500 nanoseconds ($500 \times 10^{-9}$ s) to about 5 femtoseconds ($5 \times 10^{-15}$ s).

11. The method of any one of the preceding claims, wherein the laser has a wavelength in the range from ultra-violet (150 nm) to far infra-red (20 $\mu$m).

12. A dry aerosol jet deposition apparatus (1) comprising an ablation cell (2) and a print head (3); the ablation cell (2) comprising a housing (4) defining a chamber (5) adapted to accommodate a feedstock material (10), a transparent window (6), a gas inlet (7), and an aerosol outlet (8); the print head (3) comprising a nozzle (3a) with a tip (3b); wherein the nozzle (3a) comprises an inner cylindrical channel (18) in fluid communication with an outer converging channel (19) that joins the channel (18) at an angle of between about 90° relative to the inner cylindrical channel (18), and a jet aperture (22).

13. The apparatus (1) of Claim 12, further comprising a lens (12) located between a laser source and the ablation cell (2), and adjacent the transparent window (6).

14. The apparatus (1) of any one of Claims 12 or 13, wherein the tip (3b) tapers inwards towards a jet aperture (22).

15. The apparatus of any one of Claims 12 to 14, further comprising an aerodynamic lens.

16. A product produced the method of Claim 1, wherein the product is optionally selected from an aerosoliser, a wearable device, an EMI shield, an antenna, an RFID shield, a sensor, a catheter interface, a medical device, home healthcare telemetry, a light, smartphone antennas, consumer electronic antennas, automotive electrical interconnects, IOT/MMIC/5C interconnects, middle interconnect devices.

**Figure 1**

**Figure 2A**

**Figure 2B**

Figure 3

Figure 4

Figure 5

**Figure 6**

Figure 7

Figure 8A

**Figure 8B**

**Figure 9A**

**Figure 9B**

Europäisches
Patentamt

European
Patent Office

Office européen
des brevets

**EUROPEAN SEARCH REPORT**

Application Number

EP 20 18 6825

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 058 881 B1 (KEICHER DAVID M [US] ET AL) 28 August 2018 (2018-08-28) * paragraphs [0002], [0003], [0011], [0016], [0050]; claims 1,11; figure 1 * ----- | 1-16 | INV. B05B7/22 B82Y30/00 C23C14/04 C23C14/22 |
| X | EP 2 671 970 A1 (IMRA AMERICA INC [US]) 11 December 2013 (2013-12-11) * claim 1; figure 2 * * column 1; lines 27-46 * * column 2; lines 6-56 * * column 3; lines 50-51 * * column 4; lines 30-39 * * columns 6-7; lines 51-42 * * column 7, lines 17-24 * ----- | 1-16 | C23C14/28 H01J49/04 |
| X | US 7 527 824 B2 (BECKER MICHAEL F [US] ET AL) 5 May 2009 (2009-05-05) * claims 1,3,10-12; figure 6 * * column 2; lines 49-58 * * column 3; lines 28-40 * * column 3; lines 41-46 * * column 4; lines 20-37 * * column 6; lines 32-39 * * column 7; lines 57-60 * ----- | 1-16 | |
| X | EP 1 544 168 A1 (SAMSUNG ELECTRONICS CO LTD [KR]) 22 June 2005 (2005-06-22) * paragraph [0010]; claims 1,3,6 * ----- | 1-16 | |
| X | US 2004/197493 A1 (RENN MICHAEL J [US] ET AL) 7 October 2004 (2004-10-07) * paragraphs [0062], [0071], [0073], [0094]; claims 1,2,3,13; figures 4, 7,10A-G * ----- -/-- | 1-16 | |

TECHNICAL FIELDS SEARCHED (IPC)

C23C
B05B
H01J
B82Y
B65D

The present search report has been drawn up for all claims

| Place of search | Date of completion of the search | Examiner |
|---|---|---|
| The Hague | 26 November 2020 | Momeni, Mohammad |

EPO FORM 1503 03.82 (P04C01)

page 1 of 2

Europäisches
Patentamt

European
Patent Office

Office européen
des brevets

## EUROPEAN SEARCH REPORT

Application Number

EP 20 18 6825

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 881 085 A2 (IMRA AMERICA INC [US]) 23 January 2008 (2008-01-23) * paragraphs [0002], [0009], [0016], [0018]; claims 1,20,23 * | 1-16 | |
| X | US 10 705 006 B2 (FLUIDIGM CANADA INC [CA]) 7 July 2020 (2020-07-07) * claims 1,5-7,13 * * column 1; lines 26-37 * * column 6; lines 47-52 * * column 7; lines 13-17 * * columns 7-8; lines 56-3 * * column 11; lines 59-66 * | 1-16 | |
| X | WO 2007/096487 A1 (PICODEON LTD OY [FI]; LAPPALAINEN REIJO [FI] ET AL.) 30 August 2007 (2007-08-30) * claim 1 * * pages 5-6; lest-first * * page 12; 4th , page 14: last , page 15: 2nd * * page 16; 2nd * | 1-16 | |

TECHNICAL FIELDS
SEARCHED       (IPC)

The present search report has been drawn up for all claims

| Place of search | Date of completion of the search | Examiner |
|---|---|---|
| The Hague | 26 November 2020 | Momeni, Mohammad |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 20 18 6825

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2020

| Patent document cited in search report | | | Publication date | Patent family member(s) | | | Publication date |
|---|---|---|---|---|---|---|---|
| US 10058881 | B1 | | 28-08-2018 | NONE | | | |
| EP 2671970 | A1 | | 11-12-2013 | CN | 101589173 | A | 25-11-2009 |
| | | | | CN | 103382546 | A | 06-11-2013 |
| | | | | EP | 2109694 | A2 | 21-10-2009 |
| | | | | EP | 2671970 | A1 | 11-12-2013 |
| | | | | JP | 5468908 | B2 | 09-04-2014 |
| | | | | JP | 5784081 | B2 | 24-09-2015 |
| | | | | JP | 2010518257 | A | 27-05-2010 |
| | | | | JP | 2014012897 | A | 23-01-2014 |
| | | | | US | 2008187684 | A1 | 07-08-2008 |
| | | | | US | 2009311513 | A1 | 17-12-2009 |
| | | | | US | 2014093744 | A1 | 03-04-2014 |
| | | | | WO | 2008118533 | A2 | 02-10-2008 |
| US 7527824 | B2 | | 05-05-2009 | US | 2005287308 | A1 | 29-12-2005 |
| | | | | US | 2009258244 | A1 | 15-10-2009 |
| EP 1544168 | A1 | | 22-06-2005 | DE | 602004005137 | T2 | 08-11-2007 |
| | | | | EP | 1544168 | A1 | 22-06-2005 |
| | | | | JP | 2005177983 | A | 07-07-2005 |
| | | | | KR | 20050061765 | A | 23-06-2005 |
| | | | | US | 2006049547 | A1 | 09-03-2006 |
| US 2004197493 | A1 | | 07-10-2004 | NONE | | | |
| EP 1881085 | A2 | | 23-01-2008 | EP | 1881085 | A2 | 23-01-2008 |
| | | | | JP | 5530589 | B2 | 25-06-2014 |
| | | | | JP | 2008012658 | A | 24-01-2008 |
| | | | | US | 2008006524 | A1 | 10-01-2008 |
| US 10705006 | B2 | | 07-07-2020 | CA | 2895360 | A1 | 23-10-2014 |
| | | | | CN | 105190829 | A | 23-12-2015 |
| | | | | EP | 2987177 | A1 | 24-02-2016 |
| | | | | EP | 3690923 | A1 | 05-08-2020 |
| | | | | JP | 6230693 | B2 | 15-11-2017 |
| | | | | JP | 2016522887 | A | 04-08-2016 |
| | | | | RU | 2015123440 | A | 22-05-2017 |
| | | | | SG | 10201808165Y | A | 30-10-2018 |
| | | | | SG | 11201504874Q | A | 30-07-2015 |
| | | | | US | 2016056031 | A1 | 25-02-2016 |
| | | | | US | 2017248507 | A1 | 31-08-2017 |
| | | | | US | 2018306695 | A1 | 25-10-2018 |
| | | | | US | 2019271630 | A1 | 05-09-2019 |
| | | | | WO | 2014169394 | A1 | 23-10-2014 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 20 18 6825

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2020

| Patent document cited in search report | Publication date | Patent family member(s) | Publication date |
|---|---|---|---|
| WO 2007096487 A1 | 30-08-2007 | BR PI0707014 A2 | 12-04-2011 |
| | | CA 2642867 A1 | 30-08-2007 |
| | | CN 104167464 A | 26-11-2014 |
| | | EP 1993775 A1 | 26-11-2008 |
| | | EP 1993776 A2 | 26-11-2008 |
| | | EP 1993777 A2 | 26-11-2008 |
| | | EP 1993779 A2 | 26-11-2008 |
| | | EP 1993780 A1 | 26-11-2008 |
| | | EP 1994194 A1 | 26-11-2008 |
| | | EP 1994195 A1 | 26-11-2008 |
| | | JP 5237122 B2 | 17-07-2013 |
| | | JP 5237123 B2 | 17-07-2013 |
| | | JP 5237125 B2 | 17-07-2013 |
| | | JP 5414279 B2 | 12-02-2014 |
| | | JP 2009527645 A | 30-07-2009 |
| | | JP 2009527646 A | 30-07-2009 |
| | | JP 2009527648 A | 30-07-2009 |
| | | JP 2009527914 A | 30-07-2009 |
| | | JP 2009527915 A | 30-07-2009 |
| | | KR 20080096842 A | 03-11-2008 |
| | | KR 20080096844 A | 03-11-2008 |
| | | KR 20080106552 A | 08-12-2008 |
| | | KR 20080108108 A | 11-12-2008 |
| | | KR 20090005301 A | 13-01-2009 |
| | | US 2009017318 A1 | 15-01-2009 |
| | | US 2009061210 A1 | 05-03-2009 |
| | | US 2009126787 A1 | 21-05-2009 |
| | | US 2009136739 A1 | 28-05-2009 |
| | | US 2009166812 A1 | 02-07-2009 |
| | | US 2010221489 A1 | 02-09-2010 |
| | | WO 2007096480 A1 | 30-08-2007 |
| | | WO 2007096481 A1 | 30-08-2007 |
| | | WO 2007096482 A2 | 30-08-2007 |
| | | WO 2007096483 A2 | 30-08-2007 |
| | | WO 2007096485 A2 | 30-08-2007 |
| | | WO 2007096486 A1 | 30-08-2007 |
| | | WO 2007096487 A1 | 30-08-2007 |

------------------------------------------------------------------------------

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8132744 B

**Non-patent literature cited in the description**

- **T.E. ITINA ; A. VOLOSHKO.** *Appl. Phys. B,* 2013, vol. 113, 473-478

- **KING ; BRUCE H. ; MICHAEL J. O'REILLY ; STEPHEN M. BARNES.** Characterizing Aerosol Jet® Multi-Nozzle Process Parameters for Non-Contact Front Side Metallization of Silicon Solar Cells. *Conference Record of the IEEE Photovoltaic Specialists Conference,* 2009